Europäisches Patentamt

European Patent Office

Office européen des brevets

(19)

(11) Numéro de publication : **0 115 715 B1**

(12) **FASCICULE DE BREVET EUROPÉEN**

(45) Date de publication du fascicule du brevet :
12.11.86

(51) Int. Cl.⁴ : **C 30 B 13/02, C 30 B 29/48**

(21) Numéro de dépôt : 83402265.9

(22) Date de dépôt : 23.11.83

(54) Procédé d'élaboration de composés semiconducteurs ternaires ou quaternaires.

(30) Priorité : 30.11.82 FR 8220053

(43) Date de publication de la demande :
15.08.84 Bulletin 84/33

(45) Mention de la délivrance du brevet :
12.11.86 Bulletin 86/46

(84) Etats contractants désignés :
DE GB IT NL

(56) Documents cités :
EP-A- 0 060 744
GB-A- 2 051 607
US-A- 3 849 205
JOURNAL OF CRYSTAL GROWTH, vol. 13/14, 1972, North-Holland Publishing Co. R. UEDA et al.: "Crystal growth of HgI-xCdxTe using Te as a solvent", pages 668-671
JOURNAL OF THE ELECTROCHEMICAL SOCIETY, vol. 125, no. 2, février 1978 G. FIORITO et al.: "A possible method for the growth of homogeneous mercury cadmium telluride single crystals", pages 315-317.

(73) Titulaire : **COMMISSARIAT A L'ENERGIE ATOMIQUE Etablissement de Caractère Scientifique Technique et Industriel**
31/33, rue de la Fédération
F-75015 Paris (FR)

(72) Inventeur : **Fillot, Alain**
**Chemin du Ratz Les Eymes**
**F-38330 Saint Ismier (FR)**
Inventeur : **Gallet, Jean**
**11c, Chemin de l'Eglise**
**F-38100 Grenoble (FR)**
Inventeur : **Paltrier, Sylvain**
**49 Bis, rue des Ayguinards**
**F-38240 Meylan (FR)**
Inventeur : **Schaub, Bernard**
**30, rue Gay Lussac**
**F-38000 Grenoble (FR)**

(74) Mandataire : **Mongrédien, André et al**
c/o BREVATOME 25, rue de Ponthieu
F-75008 Paris (FR)

**Description**

La présente invention concerne l'élaboration de semi-conducteurs ternaires ou quaternaires, à partir d'une zone de solvant ; et plus précisément l'amélioration, dans le cas précis des composés $Cd_xHg_{0,5-x}Te_{0,5}$ et $Cd_xHg_{0,5-x}Te_ySe_{0,5-y}$ $(0 < x < 0,5 ; 0 < y < 0,5)$, de la méthode décrite dans FR-A-2 295 792.

La méthode précédente consiste à faire traverser, à une certaine température, par une zone de solvant, des barreaux contigus d'éléments ou d'alliages d'éléments, réalisant ainsi synthèse et cristallisation de semi-conducteurs composés.

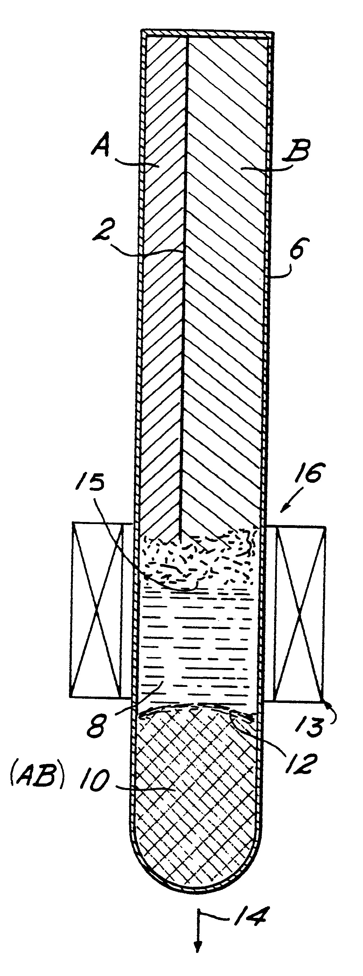

La méthode connue ainsi rappelée peut être illustrée simplement par la figure ci-jointe où l'on voit deux lingots A et B correspondant chacun à l'un des composés constitutifs du composé semi-conducteur que l'on veut réaliser.

Sur cette figure, les deux lingots A et B composant le barreau sont de forme cylindrique de même diamètre tronqués latéralement selon la face 2 et accolés par cette même face 2. L'ensemble de ces deux lingots A et B est introduit dans une nacelle cylindrique en quartz 6 en position verticale pour y être traversé par la zone de solvant 8 disposée au préalable à l'extrémité de la nacelle par laquelle débute la cristallisation et être ainsi recristallisé après passage en 10. Un four à induction par exemple représenté en 13 chauffe la partie de la nacelle et son contenu dans la partie en regard du four. La nacelle se déplace selon la flèche 14 à travers l'espace annulaire défini par le four.

En cours de croissance, on distingue successivement la zone 10 où se trouve le cristal AB, l'interface de cristallisation 12, la zone de solvant 8, l'interface de dissolution 15, une zone de début de réaction 16 où les composés sont dans une proportion proche de la stoechiométrie en vue de la réalisation du cristal AB.

D'un point de vue général, l'utilisation d'un solvant permet l'élaboration de semi-conducteurs composés à une température inférieure à la température de fusion desdits composés et, par suite, d'obtenir des matériaux plus purs et de meilleure qualité cristalline.

D'un point de vue particulier, l'utilisation d'un solvant dans le cas des composés $Cd_xHg_{0,5-x}Te_{0,5}$ et $Cd_xHg_{0,5-x}Te_ySe_{0,5-y}$ $(0 < x < 0,5 ; 0 < y < 0,5)$, permet en outre de s'affranchir des pressions de vapeur mercure élevées aux températures de fusion desdits composés.

Le procédé d'élaboration décrit dans FR-A-2 295 792, s'il répond aux considérations générales et particulières précitées, reste toutefois d'une mise en œuvre délicate quand il s'agit de l'élaboration de $Cd_xHg_{0,5-x}Te_{0,5}$ ou de $Cd_xHg_{0,5-x}Te_ySe_{0,5-y}$ $(0 < x < 0,5 ; 0 < y < 0,5)$.

En effet, d'une part, la mise en solution par le solvant (dans ce cas précis, soit le Tellure soit des liquides $Hg_yTe_z$ ou $Cd_xHg_yTe_z$ avec $z > 0,5$ et $x + y + z = 1$) des deux barres d'alliages CdTe et HgTe pour le ternaire, CdTeSe et HgTe ou CdTe et HgTeSe pour le composé quaternaire, s'effectue préférentiellement sur le chalcogénure de mercure, mettant ainsi la zone de solvant hors d'équilibre thermodynamique. Dans l'utilisation de solvant ($Hg_yTe_z$ ou $Cd_xHg_yTe_z$), z est supérieur à 0,5, c'est-à-dire en excès et il ne s'agit pas de composé mais de mélanges. Les matériaux semi-conducteurs composés ternaires ou quaternaires alors obtenus sous forme cristallisée sont dans un état qui les rend difficilement exploitables et nécessitent généralement, pour être de bonne qualité, un second passage de la zone de solvant.

D'autre part, les dispositifs électroniques fabriqués avec ces semi-conducteurs composés ternaires ou quaternaires, exigent un rapport précis de teneur en Cadmium par rapport au mercure, la fraction atomique x du cadmium devant être établie, par exemple, à mieux que 0,5 % atomique. Cette précision suppose en outre un respect rigoureux de la forme géométrique des deux barres d'alliages de départ, c'est-à-dire un usinage délicat et fastidieux de celles-ci avant leur utilisation.

La présente invention a pour objet un procédé qui permet de s'affranchir des difficultés précédentes et d'obtenir, en une seule opération, la cristallisation à basse température de matériaux ternaires et quaternaires $Cd_xHg_{0,5-x}Te_{0,5}$ et $Cd_xHg_{0,5-x}Te_ySe_{0,5-y}$ $(0 < x < 0,5 ; 0 < y < 0,5)$ présentant la qualité cristalline et l'homogénéité de composition requises.

Ce procédé d'élaboration de composés semi-conducteurs ternaires ou quaternaires $Cd_xHg_{0,5-x}Te_{0,5}$ et $Cd_xHg_{0,5-x}Te_ySe_{0,5-y}$ $(0 < x < 0,5 ; 0 < y < 0,5)$ à l'aide de la méthode connue consistant à faire traverser les composés semi-conducteurs binaires ou ternaires de base par une zone de solvant, se caractérise en ce qu'il comprend les étapes suivantes :

— on réalise un mélange homogène, de composition précise et correspondant au composé à obtenir, de poudres de CdTe et HgTe dans le cas du composé ternaire $Cd_xHg_{0,5-x}Te_{0,5}$ et de poudres de CdTeSe et HgTe ou CdTe et HgTeSe dans le cas du composé quaternaire $Cd_xHg_{0,5-x}Te_ySe_{0,5-y}$ $(0 < x < 0,5 ; 0 < y < 0,5)$ ;

— on effectue un compactage du mélange par application d'une pression ;

— on fait subir au mélange ainsi compacté un traitement thermique d'interdiffusion, assisté par un transfert de matière de grain à grain jusqu'à l'obtention d'une solution solide homogène d'un composé polycristallin ;

— on effectue enfin la recristallation du composé sous forme monocristalline à l'aide d'un passage unique dans la zone de solvant.

On voit que le procédé selon l'invention qui consiste essentiellement à substituer, aux barres d'alliage de l'art antérieur, un mélange homogène de poudres dont la composition est aussi précise que le permet une pesée à la balance, conduit à la fabrication de composés semi-conducteurs ternaires ou quaternaires à l'aide d'un seul passage dans la zone de solvant. Ceci est obtenu notamment grâce à un traitement thermique d'interdiffusion des éléments constitutifs du mélange, cette interdiffusion étant de surcroît assistée par un transfert de matière à courte distance de grain à grain, liée aux pressions de vapeurs des éléments constitutifs. Il en résulte que l'on obtient, avant le passage dans la zone de solvant, un composé solide qui est une véritable solution solide d'un matériau polycristallin ternaire ou quaternaire et non plus une juxtaposition ou un mélange de deux composés comme c'était le cas dans la technique antérieure représentée par FR-A-2 295 792.

Ce matériau de composition homogène peut en conséquence être uniformément mis en solution par le solvant, qui alors à l'équilibre thermodynamique solide-liquide, cristallise en un matériau monocristallin homogène en composition et de bonne qualité cristalline, par un unique passage de la zone de solvant.

La mise en poudre des composés initiaux peut s'effectuer par toute méthode classique de broyage, ainsi que le tamisage et la sélection des diverses granulométries. Toute granulométrie inférieure à 200 $\mu$m peut convenir, mais une répartition appropriée des différentes granulométries est souhaitable.

La pesée des poudres de composés initiaux, effectuée avec une grande précision, ainsi que leur mélange poussé, conduisent, après compactage et traitement d'interdiffusion, à un composé ternaire ou quaternaire de grande homogénéité.

Le compactage peut s'effectuer avec tout outillage classique de compactage, les pressions utilisées pouvant être comprises entre 150 et 800 MPa, et appliquées de façon programmée ou non.

Les lingots ainsi obtenus sont disposés dans une ampoule de silice, par exemple, où l'on établit le vide quelques heures et que l'on scelle soit sous vide soit sous gaz. L'ampoule peut également contenir au préalable une quantité déterminée de mercure destinée à établir une vapeur de cet élément pendant le traitement thermique, évitant ainsi toute éventuelle décomposition du chalcogénure de mercure.

Le traitement thermique d'interdiffusion s'effectue en plaçant ladite ampoule scellée dans un four, à chauffage résistif par exemple, et en l'y maintenant à une température comprise entre 450 et 700 °C environ, par exemple 600 °C, pendant quelques dizaines d'heures. La température et le temps n'ont pas a être établis avec une grande précision. Si, par ailleurs, on souhaite établir une température plus élevée, on doit tenir compte de la fusion possible du chalcogénure de mercure.

Enfin, conformément à l'invention, l'interdiffusion des éléments constitutifs est assistée par un transfert de matière lié aux pressions de vapeurs des éléments constitutifs, dans les vides intergranulaires inhérents au compactage.

Par l'expression traitement thermique d'interdiffusion assisté d'un transfert de matière à courte distance, on évoque deux phénomènes physiques.

D'une part, il est notoirement connu que deux solides distincts, mis en contact mécanique intime et chauffés, échangent leurs espèces constitutives.

Dans le cas présent, deux grains de CdTe et d'HgTe, en contact à la température de recuit, échangent respectivement des atomes de Cd et de Hg pour constituer, après le temps nécessaire, des grains solides ternaires $Cd_xHg_{0,5-x}Te_{0,5}$ $(0 < x < 0,5)$ : c'est le phénomène d'interdiffusion.

D'autre part, le compactage n'étant pas parfait, il subsiste entre les grains des petits espaces vides. Il a été démontré que du HgTe placé à peu de distance (moins de quelques millimètres) du CdTe, à une température suffisante, se transportait, *via* les vapeurs de mercure et de tellure, sur le CdTe et, échangeant alors par interdiffusion des atomes de Cd et de Hg, constituait le composé ternaire $Cd_xHg_{0,5-x}Te_{0,5}$ $(0 < x < 0,5)$. C'est ce qu'on appelle le transfert de matière à courte distance.

(Voir à cet effet par exemple les comptes rendus de l'Académie des Sciences de Paris, tome 261, 26 juillet 1965, page 931 et suivantes, l'Article « Croissance épitaxique de couches minces semiconductrices par évaporation-diffusion en régime isotherme ». Note de M. Gérard Cohen-Solal et al.).

Selon une caractéristique du procédé objet de l'invention, le solvant utilisé dans l'étape de passage dans la zone de solvant est constitué d'un mélange de Te et de HgTe ; d'une façon générale, le solvant utilisé est choisi parmi les composés comprenant le Te, le $Hg_yTe_z$ et le $Cd_xHg_yTe_z$ $(z > 0,5$ et $x + y + z = 1)$ séparément ou en combinaison.

La mise en oeuvre du procédé selon l'invention permet ainsi de réaliser un polycristal de composé semi-conducteur ternaire ou quaternaire $Cd_xHg_{0,5-x}Te_{0,5}$ et $Cd_xHg_{0,5-x}Te_ySe_{0,5-y}$ $(0 < x < 0,5 ; 0 < y < 0,5)$. Ce polycristal de composé semi-conducteur est ensuite apte à être transformé par cristallisation à basse température en un monocristal du même composé par passage unique d'une zone de solvant.

De toute façon, l'invention sera mieux comprise à la description qui suit de la mise en oeuvre du procédé d'élaboration de composés semi-conducteurs, description qui sera faite à titre illustratif et non limitatif et se réfère à la fabrication d'un semi-conducteur composé ternaire répondant à la formule $Cd_{0,15}Hg_{0,35}Te_{0,5}$.

Des alliages de CdTe et de HgTe de haute pureté sont indépendamment broyés et tamisés en poudres passant les tamis de 200 $\mu$m, 160 $\mu$m, 125 $\mu$m, 60 $\mu$m et 40 $\mu$m ; des lots de CdTe d'une part, de HgTe d'autre part sont constitués de 80 % en poids de poudre passant le tamis de 200 $\mu$m, 10 % celui de 160 $\mu$m, 6 % celui de 125 $\mu$m et 4 % celui de 60 $\mu$m. Chaque lot de CdTe pesant 7,755 g est intimement mélangé à un lot de HgTe pesant 24,745 g. Ce mélange est alors disposé dans une matrice de 24 mm de diamètre dans l'exemple décrit et compacté sous une pression de 180 MPa (la valeur de 24 mm pour le diamètre de la matrice n'est nullement critique). La pression précédente est établie progressivement en quelques minutes et supprimée de même. On dégage alors un cylindre compact d'épaisseur voisine de 11 mm contenant le mélange des poudres correspondant à la formule $Cd_{0,15}Hg_{0,35}Te_{0,5}$.

Plusieurs cylindres ainsi préparés sont disposés dans une ampoule de silice contenant au préalable une goutte pesée de mercure. L'ampoule est évacuée jusqu'à un vide de $10^{-5}$ mbar pendant cinq heures et, dans ce cas, scellée sous vide.

On commence alors le traitement thermique d'interdiffusion. A cet effet, cette ampoule est alors disposée dans un four à résistance portée à 600 °C. Le volume libre dans l'ampoule et la masse de la goutte de mercure sont tels que la pression de mercure s'établit à une valeur de $2 \times 10^5$ Pa. Cette pression de mercure n'a pas à être déterminée avec précision et pourrait être aussi élevée que $10^6$ Pa. Au cas où l'on n'introduirait pas du mercure dans l'ampoule, il serait souhaitable que le volume libre y soit réduit.

Après 20 heures de traitement thermique à 600 °C, l'ampoule est refroidie sans précaution particulière.

A ce stade on peut commencer alors la recristallisation dans la zone de solvant. A cet effet, les blocs de composés ternaires $Cd_{0,15}Hg_{0,35}Te_{0,5}$ ainsi réalisés sont disposés dans une ampoule de 24 mm de diamètre intérieur dans laquelle a été déposée au préalable une zone de solvant riche en tellure, constituée de 36 g de HgTe et 16 g de Te, zone présentant une hauteur voisine de 20 mm. Evacué et scellé sous vide, l'ensemble est introduit à la vitesse de 0,3 mm/h dans un four annulaire porté à 700 °C. Après un seul passage de la zone de solvant, on obtient un lingot de semi-conducteur composé ternaire répondant à la formule $Cd_{0,15}Hg_{0,35}Te_{0,5}$, présentant après quelques millimètres une zone monocristalline de plusieurs centimètres.

**Revendications**

1. Procédé d'élaboration de composé semi-conducteurs ternaires ou quaternaires $Cd_x Hg_{0,5-x}Te_{0,5}$ et $Cd_x Hg_{0,5-x}Te_y Se_{0,5-y}$ $(0 < x < 0,5 ; 0 < y < 0,5)$, à l'aide de la méthode connue consistant à faire traverser les composés semi-conducteurs binaires ou ternaires de base par une zone de solvant, caractérisé en ce qu'il comprend les étapes suivantes :

— on réalise un mélange homogène, de composition précise et correspondant au composé à obtenir, de poudres de CeTe et HgTe dans le cas du composé ternaire $Cd_x Hg_{0,5-x}Te_{0,5}$ et de poudres de CdTeSe et HgTe ou CdTe et HgTeSe dans le cas de composé quaternaire $Cd_x Hg_{0,5-x}Te_y Se_{0,5-y}$ $(0 < x < 0,5 ; 0 < y < 0,5)$ ;

— on effectue un compactage du mélange par application d'une pression ;

— on fait subir au mélange ainsi compacté un traitement thermique d'interdiffusion, assisté par un transfert de matière de grain à grain jusqu'à l'obtention d'une solution solide homogène d'un composé polycristallin ;

— on effectue enfin la recristallisation du composé sous forme monocristalline à l'aide d'un passage unique dans la zone de solvant.

2. Procédé selon la revendication 1, caractérisé en ce que le traitement thermique d'interdiffusion est réalisé par chauffage du mélange compacté sous vide à une température comprise entre 450 °C et 700 °C pendant une durée de l'ordre de quelques dizaines d'heures.

3. Procédé selon la revendication 1, caractérisé en ce que le traitement thermique d'interdiffusion est réalisé par chauffage du mélange compacté en atmosphère gazeuse à une température comprise entre 450 °C et 700 °C pendant une durée de l'ordre de quelques dizaines d'heures.

4. Procédé selon la revendication 3, caractérisé en ce que l'atmosphère gazeuse est de la vapeur de mercure.

5. Procédé selon l'une quelconque des revendications 1 et 2, caractérisé en ce que le solvant utilisé dans l'étape de passage dans la zone de solvant est constitué d'un mélange de Te et de HgTe.

6. Procédé selon l'une quelconque des revendications 1 et 2, caractérisé en ce que le solvant utilisé dans l'étape de passage dans la zone de solvant est choisi parmi les composés comprenant le Te, le $Hg_y Te_z$ et le $Cd_x Hg_y Te_z$ $(z > 0,5$ et $x + y + z = 1)$ séparément ou en combinaison.

**Claims**

1. Process for the preparation of ternary or quaternary semiconductor compounds $Cd_x Hg_{0,5-x}Te_{0,5}$ and $Cd_x Hg_{0,5-x}Te_y Se_{0,5-y}$ $(0 < x < 0.5 ; 0 < y < 0.5)$, by means of the known method consisting in causing a solvent zone to pass through the binary or ternary base semiconductor compounds, characterized in that it comprises the following stages :

— an homogeneous mixture is produced, of precise composition corresponding to the compound to be obtained, of CdTe and HgTe powders in the case of the ternary compound $Cd_x Hg_{0,5-x}Te_{0,5}$ and of CdTeSe and HgTe or CdTe and HgTeSe powders in the case of the quaternary compound $Cd_x Hg_{0,5-x}Te_y Se_{0,5-y}$ $(0 < x < 0,5 ; 0 < y < 0,5)$ ;

— the mixture is compacted by the application of a pressure :

— the mixture compacted in this way is subjected to a thermal interdiffusion treatment aided by a particle-to-particle transfer of material until an homogeneous solid solution of a polycrystalline compound is obtained, and

— lastly, the recrystallization of the compound in a monocrystalline form is carried out with the aid of a single passage through the solvent zone.

2. Process according to Claim 1, characterized in that the thermal interdiffusion treatment is carried out by heating the compacted mixture under vacuum at a temperature of between 450 °C and 700 °C for a period of the order of several tens of hours.

3. Process according to Claim 1, characterized in that the thermal interdiffusion treatment is carried out by heating the compacted mixture in a gaseous atmosphere at a temperature of between 450 °C and 700 °C for a period of the order of several tens of hours.

4. Process according to Claim 3, characterized in that the gaseous atmosphere is mercury vapour.

5. Process according to either of Claims 1 and 2, characterized in that the solvent used in the stage of passing through a solvent zone consists of a mixture of Te and of HgTe.

6. Process according to either of Claims 1 and 2, characterized in that the solvent employed in the stage of passing through the solvent zone is chosen from the compounds comprising Te, $Hg_yTe_z$ and $Cd_xHg_yTe_z$ ($z > 0.5$ and $x + y + z = 1$) separately or in combination.


**Patentansprüche**

1. Verfahren zur Bearbeitung von ternären oder quaternären $Cd_xHg_{0,5-x}Te_{0,5}$- und $Cd_xHg_{0,5-x}Te_ySe_{0,5-y}$-Halbleiterverbindungen (mit $0 < x < 0,5$; $0 < y < 0,5$) mit Hilfe des bekannten Verfahrens, wonach man die binären oder ternären Halbleiterausgangsverbindungen durch eine Lösungsmittelzone leitet, dadurch gekennzeichnet, daß es folgende Stufen enthält :

— man erstellt eine homogene Mischung einer bestimmten Zusammensetzung und entsprechend der zu erhaltenden Verbindung aus Pulvern von CdTe und HgTe im Falle der ternären $Cd_xHg_{0,5-x}Te_{0,5}$-Verbindung und von Pulvern aus CdTeSe und HgTe oder CdTe und HgTeSe im Falle der quaternären $Cd_xHg_{0,5-x}Te_ySe_{0,5-y}$-Verbindung (mit $0 < x < 0,5$; $0 < y < 0,5$) ;

— man bewirkt eine Verdichtung der Mischung durch Zuführung eines Drucks ;

— man unterwirft die so verdichtete Mischung einer thermischen Interdiffusionsbehandlung, unterstützt durch eine Massenübertragung von Korn zu Korn, bis man eine feste homogene Lösung einer polykristallinen Verbindung erhält ;

— man bewirkt schließlich die Rekristallisation der Verbindung in monokristalline Form mit Hilfe eines einzigen Durchlaufs durch die Lösungsmittelzone.

2. Verfahren nach Anspruch 1, dadurch gekennzeichnet, daß die thermische Interdiffusionsbehandlung durch Erwärmung des verdichteten Gemischs im Vakuum auf eine Temperatur zwischen 450 °C und 700 °C während einer Zeitdauer in der Größenordnung von einigen zehn Stunden ausführt.

3. Verfahren nach Anspruch 1, dadurch gekennzeichnet, daß die thermische Interdiffusionsbehandlung durch Erwärmung des verdichteten Gemischs in gasförmiger Atmosphäre auf eine Temperatur zwischen 450 °C und 700 °C während einer Zeitdauer in der Größenordnung von einigen zehn Stunden ausgeführt wird.

4. Verfahren nach Anspruch 3, dadurch gekennzeichnet, daß die gasförmige Atmosphäre aus Quecksilberdampf besteht.

5. Verfahren nach einem der Ansprüche 1 und 2, dadurch gekennzeichnet, daß das im Schritt des Durchlaufs durch die Lösungsmittelzone verwendete Lösungsmittel von einem Gemisch aus Te und HgTe gebildet wird.

6. Verfahren nach einem der Ansprüche 1 und 2, dadurch gekennzeichnet, daß das im Schritt des Durchlaufs durch die Lösungsmittelzone verwendete Gemisch aus den Verbindungen ausgewählt ist, die Te, $Hg_yTe_z$ und $Cd_xHg_yTe_z$, einzeln oder in Kombination, enthalten (mit $z > 0,5$ und $x + y + z = 1$).

0 115 715

1